# EUROPEAN PATENT APPLICATION

(11) **EP 3 901 997 A1**
(43) Date of publication of application: **27.10.2021**
(21) Application number: 20305385.5
(22) Date of filing: 22.04.2020
(51) Int. Cl.: H01L 21/66, C23C 16/455

(54) **ELECTRICAL DEVICE FOR CHARACTERIZING A DEPOSITION STEP SUCH AS ATOMIC LAYER DEPOSITION (ALD), AND CORRESPONDING METHODS OF FABRICATING AND CHARACTERIZING**

(71) Applicant: Murata Manufacturing Co., Ltd., Nagaokakyo-shi, Kyoto 617-8555 (JP)
(72) Inventor: LEMENAGER, Maxime, 14000 CAEN (FR); VOIRON, Frédéric, 38530 BARRAUX (FR)
(74) Representative: Cabinet Beau de Loménie

(57) **Abstract**

The invention concerns an electrical device for characterizing at least one deposition step, the device comprising a first electrical component (110A) and a second electrical component (110B) comprising respectively a first portion (103A) and a second portion (103B) of a conductive layer (102),
the first electrical component comprising a first 3D structure (105A) comprising at least one first opening (107A) extending in a layer comprising an insulating material,
the second electrical component comprising a second 3D structure (105B) comprising at least one second opening (107B) extending in a layer comprising an insulating material.

The two 3D structures have different shapes so as to allow characterizing the deposition step.

The invention also concerns a method of fabricating and a method of characterizing.

## Description

### Field of the Invention

The present invention relates to the field of characterizing deposition steps used when fabricating electrical devices. The invention applies in particular to the characterization of atomic layer deposition (ALD) steps.

### Technical Background

Electrical components such as passive components can now be integrated, for example using silicon manufacturing technologies. Silicon passive integration technologies have shown that it is possible to manufacture three-dimensional (3D) features so as to increase, for example, capacitance values of integrated capacitors.

By way of example, it has been proposed to use trenches, holes, pillars, or even porous structures to form 3D capacitors with increased capacitance values with respect to a planar capacitor occupying the same area.

Porous structures have also been used to accommodate 3D capacitors. Document "Nanotubular metal-insulator-metal capacitor arrays for energy storage" (P. Banerjee et al., published in Natural technology, May 2009), describes a metal-insulator-metal (MIM) structure formed in a porous anodic material, such as porous anodic alumina (PAA) for example. The successive layers of metal, insulator, and then metal follow the contours of the porous material resulting in the MIM structure being embedded inside the pores of the porous material.

Document WO 2015/063420 A1 also discloses 3D capacitors arranged in porous structures. In this document, the bottoms of the pores are opened and the lower metal layer of the MIM structure contacts a conductive layer that underlies the porous region.

From the above, it appears that thin film deposition methods are used to form capacitors that follow the shape of the 3D structures (for example the pores).

Also, the thin film deposition steps that are used have to be conformal so as to make full use of the 3D shapes. For example, ALD can be used to deposit electrode materials or dielectric materials of 3D capacitors.

It has been observed that ALD steps may be the source of various issues. Capacitors can be defective or have unexpected capacitance values if an ALD step used for depositing dielectrics or electrodes is not conformal. It has also been observed that some capacitors can be defective even if the ALD steps provided conformal layers. In fact, the conformality does not reflect the overall properties of a layer deposited through ALD.

In order to characterize the above mentioned structures, it has been proposed to use Transmission Electron Microscopy (TEM) so as to obtain information on the conformality and on the physical and chemical properties of the deposited materials.

TEM analyses have been observed to be too long, expensive, and difficult. Also, they often suffer from poor resolution (few samples each covering areas limited to few hundredth nanometers can only be observed).

From the prior art, document WO 2017/187016 discloses a method to characterize thin film deposition steps. In this method, a horizontal cavity is formed between a support and a membrane (either support-less or using pillars). The membrane can be peeled off after a conformal deposition step has been carried out so as to allow the visual analysis of the cavity.

The method of this document only provides morphological information. As explained above, a good conformality does not always lead to a working device and the method of this document is therefore not satisfactory to fully characterize a deposition step.

Additionally, removing the membrane is hazardous and may lead to difficulties during the post processing of the wafer from which the membrane has been peeled off if this wafer also contains functional devices. Removing the membrane is also problematic in terms of reproducibility.

There is a need for a characterization method which is simpler, and which provides more information on deposition steps than morphological information, in a more reproducible manner.

The present invention has been made in the light of the above problems.

### Summary of the Invention

The present invention provides an electrical device for characterizing at least one deposition step, the device comprising a first electrical component and a second electrical component comprising respectively a first portion and a second portion of a conductive layer of the electrical device, the first electrical component and the second electrical component being configured to allow performing an electrical characterization to characterize said deposition step, the first electrical component comprising a first 3D structure formed in a layer having a top face, comprising an insulating material, and arranged on the first portion of the conductive layer, the first 3D structure comprising at least one first opening extending in the layer comprising an insulating material from the top face of this layer so as to reach the first portion of the conductive layer at the bottom of the at least one first opening and so as to expose the insulating material in the sidewalls of the opening, the second electrical component comprising a second 3D structure formed in the layer comprising an insulating material and arranged on the second portion of the conductive layer, the second 3D structure having a 3D shape which differs from the 3D shape of the first 3D structure, the second 3D structure comprising at least one second opening extending in the layer comprising an insulating material from the top face of this layer so as to reach the second region of the conductive layer at the bottom of the at least one second opening and so as to expose the insulating material in the sidewalls of the opening.

The first portion and the second portion of the conductive layer are distinct from each other (there is no overlapping between the two portions). The conductive layer may be formed on a substrate, for example a substrate comprising a semiconductor material such as a silicon wafer.

3D structures are structures which present a relief and in the present invention openings. The above 3D structures may be formed, for example, by removing material from a layer (the comprising the insulating material) which has been deposited on the conductive layer so as to form this relief.

The openings are through openings, i.e. not blind holes that open on the layer comprising an insulating material, and extend in the entire thickness of the layer comprising an insulating material. The insulating material will therefore be arranged in this layer so that forming the openings exposes this insulating material at least on the sidewalls of the openings.

The combination of different 3D structures with openings comprising an insulating material and of a conductive layer onto which the openings open below the 3D structures allows forming electrical components which will have an electrical behavior which depends on the properties of at least:
the 3D structures and their openings, and
any layer subsequently deposited on the 3D structures.

Typically, information regarding the conformality of the subsequent deposition step (the step to be characterized) can be obtained because how the bottom of the openings will be filled will affect the electrical properties of the electrical components.

Because the deposition step to be characterized may not have been carried out yet on the device, the device can be used to perform characterization on various deposition machines, for example.

These properties may relate the morphology of these two elements (i.e. the thickness, the conformality, the shape of the 3D structures, etc.), but also to all the other properties that are affected by the composition of the materials, the stoichiometry of the materials, etc. Because it is an electrical behavior which is observed when an electrical component is used during an electrical characterization, all those properties may be analyzed.

Electrical characterization can include, for example, measuring a capacitance, a resistance, and/or an inductance of each electrical component.

Using at least two different electrical components allows performing comparisons which then allow characterizing the deposition step.

Compared with the methods of the prior art which are structural, the above method is electrical and allows characterizing a subsequent deposition step during which a layer of a given material is formed but also the formation of the 3D structures (for example an anodization to form pores or a deep reactive ion etching step).

Also, a component configured to allow performing an electrical characterization to characterize said deposition step is a component that allows the performing direct measurements by means of a probe of electrical parameters (resistance, capacitance, inductance, etc.) so as to deduce that the deposition step has been performed in a certain manner. This probe may be connected to the electrical component on a pad subsequently formed.

Using electrical measurements on the above defined 3D structures also allows performing easily reproducible measurements.

The electrical parameter can be chosen so as to reflect the conformality of the deposition step.

According to a particular embodiment, the at least one first opening and the at least one second opening are chosen in the group comprising holes, trenches, and pores.

Preferably, the first and the second 3D structure comprise a same pattern of holes/trenches or pores but with a geometrical difference. Thus, the 3D structure may comprise a same number of holes/trenches, or a substantially similar number of pores which may differ in terms of width and/or height.

Preferentially, the two 3D structures comprise the same type of structure element. Also, the two 3D structures may comprise only one type of structure element.

It should be noted that in the present application, the expression pore refers to a pore obtained by anodization of a material (for example anodization of aluminum to obtain pores in alumina). The pores can also be called anodic pores. A plurality of anodic pores forms a porous region. Anodic pores may be substantially straight, for example vertical.

Also, the trenches of the present invention can be straight trenches, or trenches formed around pillars. The holes can be cylindrical holes. Holes and trenches can be obtained by patterning an insulating layer.

It should be noted that the 3D structures can be also obtained by sintering an insulating powder to obtain openings going through the pores until reaching the conductive layer.

According to a particular embodiment, the at least one first opening and the at least one second opening are each associated with a characteristic height and/or a characteristic width, and wherein the characteristic height and/or the characteristic width of the first opening differs from the characteristic height and/or the characteristic width of the second opening.

For example, if the two 3D structures comprise holes as openings, the holes of each 3D structure are associated with:
- a characteristic height which may be substantially the height from the bottom of the holes to the top of the holes, for example the mean value of the height of all the holes,
- a characteristic width which may be substantially the width of all the holes of this 3D structure or the width between all the holes of this 3D structure, for example the mean value of the width of all the holes.

For example, if the two 3D structures comprise trenches as openings, the trenches of each 3D structure are associated with:
- a characteristic height which may be substantially the height from the bottom of the trenches to the top of the trenches, for example the mean value of the height of all the trenches,
- a characteristic width which may be substantially the width of all the trenches of this 3D structure or the width between all the trenches of this 3D structure, for example the mean value of the width of all the trenches.

For example, if the two 3D structures comprise pores (anodic pores) as openings, the pores of each 3D structure are associated with:
- a characteristic height which may be substantially the height from the bottom of the pores to the top of the pores (typically an average height),
- a characteristic width which may be substantially the width of all the pores of this 3D structure (typically an average pore diameter).

According to a particular embodiment, the first portion of the conductive layer has a first area, and the second portion of the conductive layer has a second area which differs from the first area.

In this particular embodiment, the first electrical component occupies an area which differs from the area occupied by the second electrical component. This difference in occupied area also leads to a difference in the 3D shape. For example, two 3D structures of two electrical components comprising pores having a same characteristic height and a same characteristic width may have different 3D shape because they occupy different areas.

This particular embodiment is particularly useful to verify how the area influences a deposition step.

According to a particular embodiment, the sidewalls of the at least one first opening and of the at least one second opening only comprise the insulating material.

The 3D structures may be formed in a monolithic layer only comprising the insulating material.

In an alternative embodiment, the 3D structures may be formed in a layer comprising several materials, with the insulating material is present at least in the sidewalls of the 3D structures.

According to a particular embodiment, the first component comprises a first portion of a layer of a given material arranged on the first 3D structure, and the second component comprises a second portion of a layer of a given material arranged on the second 3D structure.

Forming the layer of the given material can be performed through the deposition step to be characterized.

Also, the first portion and the second portion of the layer of the given material are distinct from each other (there is no overlapping between the two portions). The layer of a given material may be formed by a single deposition step so as to cover the first 3D structure and the second 3D structure simultaneously.

According to a particular embodiment, a first sub portion of the first portion of the layer of the given material is arranged substantially at the bottom of the first opening on a first sub portion of the first portion of the conductive layer and a second sub portion of the second portion of the layer of the given material is arranged substantially at the bottom of the second opening on a second sub portion of the conductive layer.

The person skilled in the art will understand that by substantially arranged, what is meant is that the layer of the given material is at least in contact with a part of the sub portion of the opening.

According to a particular embodiment, the given material is a dielectric material,
the first electrical component further comprising a first electrode deposited on the first portion of layer of the given material so as to form at least one first capacitor of the first electrical component, the first sub-portion of the conductive layer forming the other electrode of the at least one first capacitor,
the second electrical component further comprising a second electrode deposited on the second portion of layer of the given material so as to form at least one second capacitor of the second electrical component, the second sub-portion of the conductive layer forming the other electrode of the at least one second capacitor.

In this particular embodiment, performing an electrical characterization on each electrical component may include measuring a capacitance value and/or a leakage current value and/or a breakdown voltage value and/or a scattering of one the previous parameters between capacitors and/or the lifetime of the capacitor. The measured value will reflect the thickness at the bottom of the openings and the conformality of the deposition step used for the layer of a given material. The measured value may also reflect how the formation of the 3D structures has been performed.

Alternatively, the given material is a conductive material. The electrical parameter to be measured can be the resistance, to characterize the deposition of the conductive material.

Also, the capacitors of this embodiment may comprise a plurality of sub-capacitors each arranged at the bottom of the openings and connected in parallel, depending on the shape of the 3D structures.

According to a particular embodiment, the electrical device comprises a number N of electrical components with N>2, each electrical component of the N electrical components comprising a 3D structure having a 3D shape which differs from the 3D shape of the 3D structures of the other electrical components of the N electrical components.

The N electrical components may, for example, present a given distribution of characteristic height or characteristic width or area, for example a range.

According to a particular embodiment, the device further comprises an additional electrical component formed above an additional portion of the conductive layer of the electrical device, the additional electrical component comprising being a 2D component.

For example, the additional electrical component can be a planar capacitor. This capacitor can be used so has to have a reference value of the electrical parameter which is not affected by the 3D relief of the 3D structures.

The invention also provides a method of fabricating an electrical device for characterizing at least one deposition step comprising:
obtaining a conductive layer having a first portion and a second portion,
forming a layer comprising an insulating material on the first portion and on the second portion of the conductive layer, the insulating layer having a top face,
forming a first electrical component including forming a first 3D structure in the layer comprising an insulating material, the first 3D structure being arranged on the first portion of the conductive layer, the first 3D structure comprising at least one first opening extending in the layer comprising an insulating material from the top face of this layer so as to reach the first portion of the conductive layer at the bottom of the at least one first opening and so as to expose the insulating material in the sidewalls of the first opening, the first electrical component comprising the first 3D structure and the first portion of the conductive layer,
forming a second electrical component including forming a second 3D structure in the layer comprising an insulating material, the second 3D structure being arranged on the second portion of the conductive layer, the second 3D structure comprising at least one second opening extending in the layer comprising an insulating material from the top face of this layer so as to reach the second portion of the conductive layer at the bottom of the at least one second opening and so as to expose the insulating material in the sidewalls of the second opening, the second electrical component comprising the second 3D structure and the second portion of the conductive layer,
wherein the first electrical component and the second electrical component are configured to allow performing an electrical characterization to characterize said deposition step.

This method may be configured to fabricate any embodiment of the electrical device as defined above.

According to a particular embodiment, forming the first electrical component comprises depositing a first portion of a layer of a given material on the first 3D structure, and forming the second electrical component comprises depositing a second portion of a layer of a given material on the second 3D structure.

According to a particular embodiment, the layer of a given material is deposited by atomic layer deposition.

Forming the openings that reach the conductive layer may be done in a single etching step or in a plurality of steps. For example, if the 3D structures comprise pores, an anodization process is carried out to form initial pores and a subsequent etching step is carried out to etch the bottom of the bores should any material remain at the bottom of the pores.

The invention also provides a method of characterizing at least one deposition step using an electrical device as defined above, comprising measuring the value of an electrical parameter for the first electrical component of the electrical device, measuring a value of the same electrical parameter for the second electrical component of the electrical device, characterizing said at least one deposition step being performed on the basis of the measured values of the electrical parameter.

According to a particular embodiment, the electrical parameter is the capacitance and/or the leakage current and/or the breakdown voltage value and/or a scattering of one of the previous parameters between capacitors and/or the lifetime.

According to a particular embodiment, the electrical device comprises said additional component and the method includes measuring a value of the same electrical parameter for the additional electrical component.

### Brief Description of the Drawings

Further features and advantages of the present invention will become apparent from the following description of certain embodiments thereof, given by way of illustration only, not limitation, with reference to the accompanying drawings in which:
Figure 1 is a side view of an electrical device according to an example,
Figure 2 is a side view of an electrical device according to an example,
Figure 3 shows the sub-capacitors formed at the bottom of pores, and
Figure 4 is a top view of an electrical device according to an example.

### Detailed Description of Example Embodiments

We will now describe an electrical device for characterizing at least one deposition step, the associated fabrication method, and a method for characterizing this step using the electrical device.

In the examples described hereinafter, the step to be characterized is an Atomic Layer Deposition (ALD) step. The invention is however not limited to characterizing this step and the proposed device also allows characterizing other deposition processes and processes directed to, for example, patterning or forming 3D structures. Also, for devices aimed at characterising deposition steps, this deposition step can be a subsequent deposition step, not yet performed on the device which is still configured so that this subsequent deposition step will allow characterization to be performed.

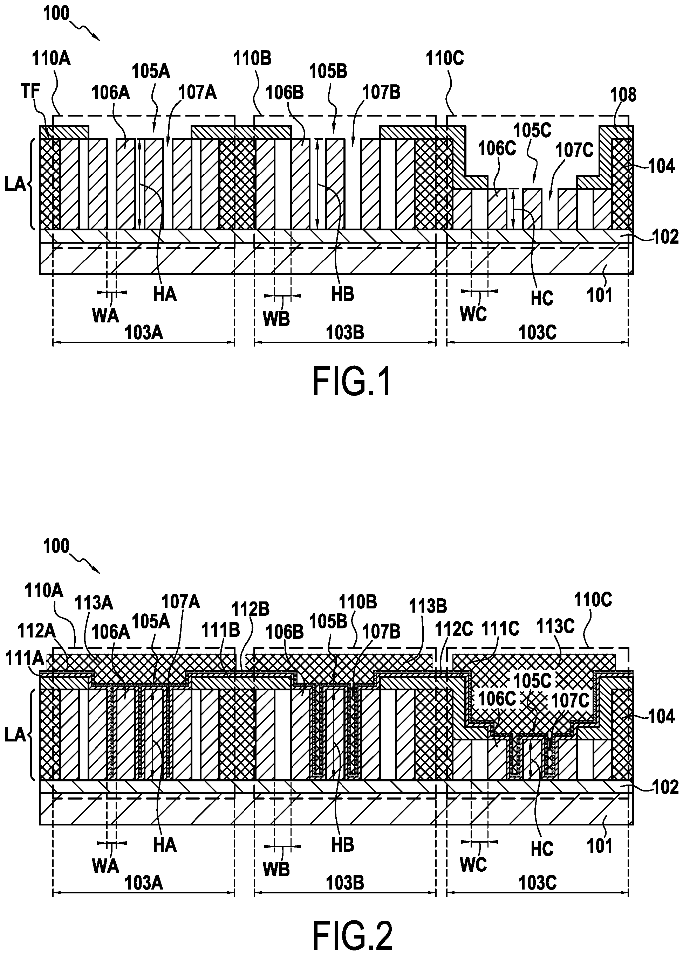

Figure 1 is a side view of an electrical device 100 according to an example. This device is formed on a silicon substrate 101, which can be part of a silicon wafer. The device 100 can be fixedly associated with similar devices on this silicon device, or it can also be separated if this wafer has been diced.

Above the silicon substrate 101, a conductive layer 102 has been formed. For example, this conductive layer 102 can be a barrier layer as disclosed in document WO 2015 063420, and it can comprise Tungsten, Titanium, Tantalum, Titanium Nitride, or Tantalum Nitride. Using a material which can be used as a barrier facilitates the subsequent formation of porous regions, as will be described hereinafter. Also, the conductive layer comprises three portions 103A, 103B, and 103C visible on the figure, which are distinct from one another and correspond to adjacent portions of the conductive layer.

Above and on the conductive layer 102, an aluminium layer 104 is formed by deposition, before forming three separate 3D structures 105A, 105B, and 105C respectively above the portions of the conductive layer 103A, 103B, and 103C.

The 3D structures, in the present example, are formed by anodization of the aluminium layer 104, using a process similar to the one described in document WO 2015 063420, so that three separate porous alumina regions 106A, 106B, and 106C are obtained respectively above the portions 103A, 103B, and 103C of the conductive layer. The three porous alumina regions 106A, 106B, and 106C also respectively comprise the 3D structures 105A, 105B, and 105C. The porous alumina regions are insulating.

Thus, a layer LA is obtained which contains an insulating material, in the three porous alumina regions 106A, 106B, and 106C. This layer has a top face TF.

In the 3D structures 105A, 105B, and 105C, vertical and straight pores are formed and form openings.

In the 3D structure 105A, pores 107A are formed, and these pores extend from the top face TF of the layer LA so as to reach the portion 103A of the conductive layer and so that alumina is exposed in the sidewalls of the pores 107A. It should be noted that the anodization can be followed by an etching step so as to ensure that the pores open onto the conductive layer. The pores 107A have a height HA and a width WA (for example, HA and WA are mean values over all the pores 107A).

Similarly, in the 3D structure 105B, pores 107B are formed, and these pores extend from the top face TF of the layer LA so as to reach the portion 103B of the conductive layer and so that alumina is exposed in the sidewalls of the pores 107B. The pores 107B have a height HB and a width WB (for example, HB and WB are mean values over all the pores 107B).

Similarly, in the 3D structure 105C, pores 107C are formed, and these pores extend from the top face TF of the layer LA so as to reach the portion 103C of the conductive layer and so that alumina is exposed in the sidewalls of the pores 107C. The pores 107C have a height HC and a width WC (for example, HC and WC are mean values over all the pores 107C).

It should be noted that obtaining distinct porous regions can be obtained by use of a hard mask 108.

Also, and as can be observed on the figure, WA is smaller than WB and WC which WC are equal. Concerning heights, HC is smaller than HA and HB which are equal. Thus, the 3D shape of each 3D structure 105A to 105C is different.

Thus, three electrical components are obtained:
- Electrical component 110A comprising the 3D structure 105A and the portion 103A of the conductive layer,
- Electrical component 110B comprising the 3D structure 105B and the portion 103B of the conductive layer, and
- Electrical component 110C comprising the 3D structure 105C and the portion 103C of the conductive layer,

These electrical components are all equipped with 3D structures which have a different shape (because of the difference in terms of dimensions).

These electrical components are configured to allow performing an electrical characterization, for example by forming a connection pad so that an electrical contact can be formed on top of the 3D structures, for example after subsequent deposition steps.

It should be noted that the electrical components 110A to 110C are electrical components because they include a conductive layer and a 3D structure (here fully insulating) which will affect some electrical properties which can be measured on this device.

Furthermore, because of their 3D structures having different shapes, the electrical parameters which will be measured by electrical characterization may differ, for example in a manner which depends on both the electrical parameter and the 3D shape of the 3D structure, especially if the subsequent deposition step is not conformal, for example uneven.

It should be noted that more than three electrical components can be used, and that the differences in 3D shape can be selected according to the deposition step to characterize.

Figure 2 shows an electrical device 100 according to another example and which corresponds to the electrical device of figure 1 with additional steps having been carried out. The elements designated by the same references on figures 1 and 2 are identical.

A layer of dielectric material, for example silicon dioxide, is formed above the 3D structures 105A, 105B, and 105C. Above the 3D structure 105A, a portion 111A of the layer of dielectric material is obtained, above the 3D structure 105B, a portion 111B of the layer of dielectric material is obtained, and above the 3D structure 105C, a portion 111C of the layer of dielectric material is obtained.

Forming the layer of dielectric material can comprise an Atomic Layer Deposition (ALD) step, and this step may be the step to be characterized using the device, for example the electrical device 100 of figures 1 and 2.

For example, the characterization can lead to determining whether or not the ALD step is conformal.

In the illustrated example which is schematic, the ALD step is conformal and there is a sub-portion of the layer of dielectric material at the bottom of each pore, on a sub-portion of the corresponding portion of the conductive layer.

Above the portion 111A of the layer of dielectric material, an electrode 112A is formed using a conductive material, for example titanium nitride. Thus, a capacitor of the electrical component 110A is formed at the bottom of each pore, and this capacitor comprises a sub-portion of the portion 103A, a sub-portion of the layer of dielectric material at the bottom of the pore, and a sub-portion of the electrode 112A. Whether or not the ALD step is conformal will affect the capacitance of this capacitor (the quantity of dielectric material deposited at the bottom of a pore is an illustration of the conformality, and this quantity affects the capacitance). Also, other electrical parameters will be affected by the quality of the deposition step: the leakage current, the breakdown voltage value, a scattering of one the previous parameters between capacitors, the lifetime.

Similarly, above the portion 111B of the layer of dielectric material, an electrode 112B is formed. Thus, a capacitor of the electrical component 110B is formed at the bottom of each pore, and this capacitor comprises a sub-portion of the portion 103B, a sub-portion of the layer of dielectric material at the bottom of the pore, and a sub-portion of the electrode 112B.

Similarly, above the portion 111C of the layer of dielectric material, an electrode 112C is formed. Thus, a capacitor of the electrical component 110C is formed at the bottom of each pore, and this capacitor comprises a sub-portion of the portion 103C, a sub-portion of the layer of dielectric material at the bottom of the pore, and a sub-portion of the electrode 112C.

Conductive pads 113A, 113B, and 113C are also respectively formed on the electrodes 112A, 112B, and 112C. These pads facilitate performing an electrical characterization on each electrical component, for example to measure capacitance. It should be noted that the conductive layer 102 can be electrically accessed through another pad not shown on the figure.

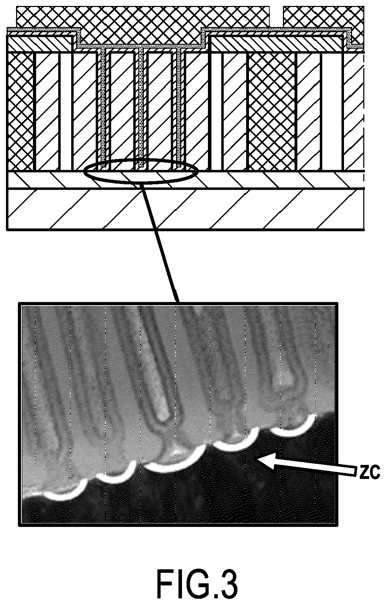

Figure 3 shows the sub-capacitors formed at the bottom of pores highlighted on a Transmission Electron Microscopy image in a zone ZC. The 3D shape of the pores and the conformal character of the ALD step will determine the capacitance value and other electrical parameters (leakage current, breakdown voltage, etc.).

Using a plurality of different shapes also provides information on the limits of the step to be characterized. For example, deep and narrow pores may prevent conformal depositions, and the device of figures 1 and 2, can provide information on the limits that can be reached while maintaining conformality.

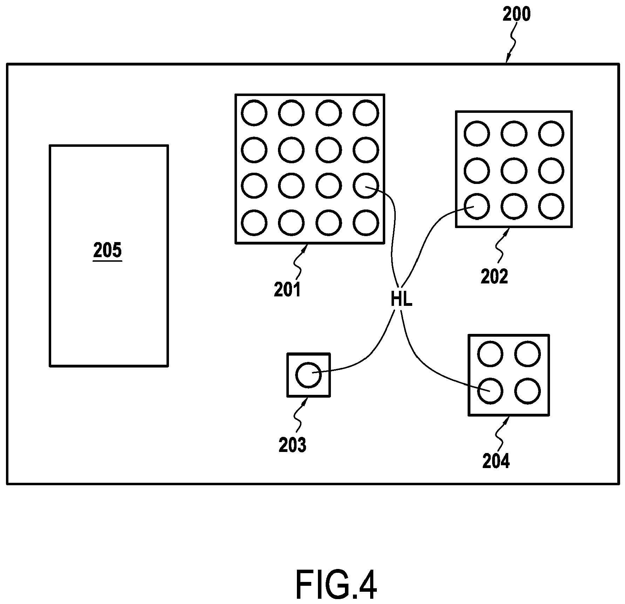

Figure 4 is another example, schematically represented, of an electrical device 200 comprising four electrical components 201, 202, 203, and 204 each including a 3D structure comprising holes HL, for example obtained using Deep Reactive Ion Etching.

The 3D structures of the electrical components 201 to 204 differ in that the surface area that they occupy changes, but the dimensions of the holes HL remains the same. This embodiment allows determining whether the area associated with a deposition step will have an impact on this deposition step.

The device 200 further comprises an additional electrical component 205 which is a planar component which can be used to provide a reference value for the electrical parameter to be measured.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

## Claims

1. An electrical device for characterizing at least one deposition step, the device comprising a first electrical component (110A) and a second electrical component (110B) comprising respectively a first portion (103A) and a second portion (103B) of a conductive layer (102) of the electrical device, the first electrical component and the second electrical component being configured to allow performing an electrical characterization to characterize said deposition step, the first electrical component comprising a first 3D structure (105A) formed in a layer having a top face (TF), comprising an insulating material, and arranged on the first portion of the conductive layer, the first 3D structure comprising at least one first opening (107A) extending in the layer comprising an insulating material from the top face of this layer so as to reach the first portion of the conductive layer at the bottom of the at least one first opening and so as to expose the insulating material in the sidewalls of the opening,
the second electrical component comprising a second 3D structure (105B) formed in the layer comprising an insulating material and arranged on the second portion of the conductive layer, the second 3D structure having a 3D shape which differs from the 3D shape of the first 3D structure, the second 3D structure comprising at least one second opening (107B) extending in the layer comprising an insulating material from the top face of this layer so as to reach the second region of the conductive layer at the bottom of the at least one second opening and so as to expose the insulating material in the sidewalls of the opening.

2. The electrical device of claim 1, wherein the the at least one first opening and the at least one second opening are chosen in the group comprising holes, trenches, and pores (107A, 107B).

3. The electrical device of claim 1 or 2, wherein the at least one first opening and the at least one second opening are each associated with a characteristic height (HA, HB) and/or a characteristic width (WA, WB), and wherein the characteristic height and/or the characteristic width of the first opening differs from the characteristic height and/or the characteristic width of the second opening.

4. The electrical device of any one of claims 1 to 3, wherein the first portion of the conductive layer has a first area, and the second portion of the conductive layer has a second area which differs from the first area.

5. The electrical device of any one of claims 1 to 4, wherein the sidewalls of the at least one first opening and of the at least one second opening only comprise the insulating material.

6. The electrical device of any one of claims 1 to 5, wherein the first component comprises a first portion (111A) of a layer of a given material arranged on the first 3D structure, and the second component comprises a second portion (111B) of a layer of a given material arranged on the second 3D structure.

7. The electrical device of claim 6, wherein a first sub portion of the first portion of the layer of the given material is arranged substantially at the bottom of the first opening on a first sub portion of the first portion of the conductive layer and a second sub portion of the second portion of the layer of the given material is arranged substantially at the bottom of the second opening on a second sub portion of the conductive layer.

8. The electrical device of claim 7, wherein the given material is a dielectric material,
the first electrical component further comprising a first electrode (112A) deposited on the first portion of layer of the given material so as to form at least one first capacitor of the first electrical component, the first sub-portion of the conductive layer forming the other electrode of the at least one first capacitor,
the second electrical component further comprising a second electrode (112B) deposited on the second portion of layer of the given material so as to form at least one second capacitor of the second electrical component, the second sub-portion of the conductive layer forming the other electrode of the at least one second capacitor.

9. The electrical device of any one of claims 1 to 8, comprising a number N of electrical components with N>2,
each electrical component of the N electrical components comprising a 3D structure having a 3D shape which differs from the 3D shape of the 3D structures of the other electrical components of the N electrical components.

10. The electrical device of any one of claims 1 to 9, further comprising an additional electrical component formed above an additional portion of the conductive layer of the electrical device, the additional electrical component comprising being a 2D component.

11. A method of fabricating an electrical device for characterizing at least one deposition step comprising:
obtaining a conductive layer (102) having a first portion (103A) and a second portion (103B),
forming a layer comprising an insulating material on the first portion and on the second portion of the conductive layer, the insulating layer having a top face (TF),
forming a first electrical component (110A) including forming a first 3D structure (105A) in the layer comprising an insulating material, the first 3D structure being arranged on the first portion of the conductive layer, the first 3D structure comprising at least one first opening (107A) extending in the layer comprising an insulating material from the top face of this layer so as to reach the first portion of the conductive layer at the bottom of the at least one first opening and so as to expose the insulating material in the sidewalls of the first opening, the first electrical component comprising the first 3D structure and the first portion of the conductive layer,
forming a second electrical component (110B) including forming a second 3D structure (105B) in the layer comprising an insulating material, the second 3D structure being arranged on the second portion of the conductive layer, the second 3D structure comprising at least one second opening (107B) extending in the layer comprising an insulating material from the top face of this layer so as to reach the second portion of the conductive layer at the bottom of the at least one second opening and so as to expose the insulating material in the sidewalls of the second opening, the second electrical component comprising the second 3D structure and the second portion of the conductive layer,
wherein the first electrical component and the second electrical component are configured to allow performing an electrical characterization to characterize said deposition step.

12. The method according to claim 11, wherein forming the first electrical component comprises depositing a first portion (111A) of a layer of a given material on the first 3D structure, and forming the second electrical component comprises depositing a second portion (111B) of a layer of a given material on the second 3D structure.

13. The method according to claim 12, wherein the layer of a given material is deposited by atomic layer deposition.

14. A method of characterizing at least one deposition step using an electrical device in accordance with any one of claims 1 to 10, comprising measuring the value of an electrical parameter for the first electrical component of the electrical device, measuring a value of the same electrical parameter for the second electrical component of the electrical device, characterizing said at least one deposition step being performed on the basis of the measured values of the electrical parameter.

15. The method according to claim 14, wherein the electrical parameter is the capacitance and/or the leakage current and/or the breakdown voltage value and/or a scattering of one of the previous parameters between capacitors and/or the lifetime.

16. The method according to claim 14 or 15, wherein the electrical device is an electrical device in accordance with claim 10, and wherein the method includes measuring a value of the same electrical parameter for the additional electrical component.
